# EUROPÄISCHE PATENTSCHRIFT

(11) **EP 1 006 556 B1**
(45) Veröffentlichungstag und Bekanntmachung des Hinweises auf die Patenterteilung: **03.08.2005**
(21) Anmeldenummer: 99122179.7
(22) Anmeldetag: 06.11.1999
(51) Int. Cl.: H01J 37/317, G03F 7/20

(54) **Teilchenoptische Anordnung und Verfahren zur teilchenoptischen Erzeugung von Mikrostrukturen**
Particle-optical device and method for producing microstructures
APPAREIL D'OPTIQUE PARTICULAIRE pour la fabrication de microstructures

(30) Priorität: 02.12.1998 DE 19855629
(43) Veröffentlichungstag der Anmeldung: 07.06.2000
(73) Patentinhaber: Carl Zeiss NTS GmbH, 73446 Oberkochen (DE)
(72) Erfinder: Benner, Gerd, Dr., 73434 Aalen (DE)
(74) Vertreter: Gnatzig, Klaus

(56) Entgegenhaltungen:
- EP-A- 0 772 225
- US-A- 5 079 112

## Beschreibung

Zur teilchenoptischen Erzeugung von Mikrostrukturen, beispielsweise für die Halbleiterlithographie, ist es bekannt, eine verkleinert abzubildende Maske entweder als freitragende Maske oder als dünne Membran mit stark streuenden dickeren Strukturen auszubilden. Bei den freitragenden Masken sind jedoch keine Hohlstrukturen, d.h. Strukturen, die keine Verbindung zum Maskenrand aufweisen, möglich. Da jedoch in der Halbleiterlithographie auch die Projektion derartiger Hohlstrukturen erforderlich ist, ist der Anwendungsbereich freitragender Masken stark begrenzt. Außerdem kommt es durch Teilchenabsorption auf der Maskenstruktur zu einer unterschiedlichen Erwärmung der Maske, woraus leicht ein Maskenverzug resultiert.

Bei transparenten Masken, bei denen eine stark streuende Struktur auf einer dünnen, schwach streuenden Membran aufgebracht ist, treten diese Nachteile nicht auf Dafür ergibt sich jedoch der Nachteil eines recht geringen Kontrastes, da die Kontrasterzeugung, wie dieses beispielsweise aus der US-A-5079112 bekannt ist, über eine der Maske nachgeschaltete Aperturblende erfolgt, die entweder nur die unter einem großen Streuwinkel aus der Maske austretenden Teilchen transmittieren läßt - dieses entspricht im wesentlichen einem Dunkelfeldkontrast - oder nur die unter kleinen Streuwinkeln aus der Maske austretenden Teilchen transmittieren läßt - dieses entspricht im wesentlichen einem Hellfeldkontrast. Da jedoch sowohl stark als auch schwach streuende Bereiche stets große Streuwinkelbereiche erzeugen, die sich nur in deren statistischer Verteilung unterscheiden, resultiert der bereits oben genannte schwache Kontrast.

Es ist daher das Ziel der vorliegenden Erfindung, eine teilchenoptische Anordnung und ein teilchenoptisches Verfahren anzugeben, mit der (dem) auf einer dünnen Membran aufgebrachte Mikrostrukturen mit hohem Kontrast abgebildet werden können.

Dieses Ziel wird durch eine teilchenoptische Anordnung mit den Merkmalen des Anspruches 1 und durch ein Verfahren mit den Merkmalen des Anspruches 11 gelöst. Vorteilhafte Ausführungsformen der Erfindung ergeben sich aus den Merkmalen der abhängigen Ansprüche.

Die erfindungsgemäße teilchenoptische Anordnung weist ein der Mikrostruktur tragenden Maske nachgeschaltetes abbildendes Energiefilter auf Mit Hilfe des Energiefilters werden inelastisch gestreute Teilchen eines vorgegebenen Energiefensters herausgefiltert. Durch ein dem Energiefilter nachgeschaltetes Abbildungssystem erfolgt dann die verkleinerte Abbildung der Maske in die Bild- oder Projektionsebene.

Der Erfindung liegt demzufolge die Idee zugrunde, für die Kontrasterzeugung eine Trennung der Teilchen nach ihrer Energie bzw. nach ihrem energetischen Unterschied nach Wechselwirkung mit der abzubildenden Maske auszunutzen. Da der Energieverlust der Teilchen stark elementspezifisch ist, läßt sich durch Verwendung unterschiedlicher Materialien für die Membran einerseits und die Mikrostruktur andererseits ein hoher Abbildungskontrast erzeugen. Dabei stört es auch nicht, wenn sowohl die Membran als auch die Mikrostruktur inelastisch streuen, solange sich die Energieverlustspektren der für die Membran und die Mikrostruktur eingesetzten Materialien hinreichend unterscheiden, so daß eine energetische Trennung der inelastisch gestreuten von den inelastisch gestreuten Teilchen am Ausgang des Energiefilters möglich ist. Bevorzugt in Verbindung mit der erfindungsgemäßen Anordnung und dem erfindungsgemäßen Verfahren ist es jedoch, wenn die die Mikrostruktur tragende Maske aus einer die Teilchen elastisch streuenden Trägerfolie mit einer inelastisch streuenden Mikrostruktur besteht. In einem solchen Fall werden vorzugsweise die inelastisch gestreuten Teilchen am Ausgang des Energiefilters herausgefilter, so daß zur Abbildung der Maske nur die elastisch gestreuten Teilchen beitragen, da diese die geringste spektrale Verteilung aufweisen.

Die Abbildung der Maskenebene in die Bildebene sollte dabei derart erfolgen, daß das Abbild der Maske in der Bildebene höchstens halb so groß ist wie die Maske (Abbildungsmaßstab kleiner 0,5).

Das Energiefilter sollte vorzugsweise als sogenanntes abbildendes Energiefilter ausgebildet sein, das eine erste eingangsseitige Ebene - die Eingangsbildebene - achromatisch in eine erste ausgangsseitige Ebene - Ausgangsbildebene - und eine zweite eingangsseitige Ebene - Eingangsbeugungsebene - dispersiv in eine zweite ausgangsseitige Ebene - dispersive Ebene - abbildet. Die Maske sollte dann entweder in der ersten eingangsseitigen Ebene angeordnet oder durch eine der Maske nachgeschaltete Abbildungsstufe in diese erste eingangsseitige Ebene des Filters abgebildet sein.

In bzw. hinter der Bildebene der Anordnung ist vorzugsweise ein Präparathalter angeordnet, der zur Aufnahme des zu strukturierenden Wafers dient. Dieser Präparathalter sollte in zwei zueinander senkrechten Richtungen, die senkrecht zur optischen Achse der teilchenoptischen Anordnung stehen, motorisch bewegbar sein. In der Maskenebene sollte ebenfalls ein die Maske aufnehmender, in zwei zueinander senkrechten Richtungen, die wiederum senkrecht zur optischen Achse der teilchenoptischen Anordnung stehen, motorisch bewegbarer Präparathalter angeordnet sein. Durch entsprechende bewegungsmäßige Kopplung des Präparathalters in der Maskenebene mit der Bewegung des Präparathalters in der Bildebene können sukzessiv unterschiedliche Bereiche der Maske auf unterschiedliche Bereiche des in der Bildebene anzuordnenden Wafers energiegefiltert abgebildet werden, so daß durch sukzessive Projektion Maskenfelder abgebildet werden können, die größer als das jeweils übertragene Bildfeld sind.

Zwischen Teilchenquelle und der Maskenebene kann ein Kondensorsystem vorgesehen sein. Ein solchen Kondensorsystem ermöglicht es, in der Maskenebene einen kollimierten Strahlengang vorzusehen.

Weiterhin kann zwischen der Teilchenquelle und der Maskenebene ein erstes Ablenksystem, zwischen der Maskenebene und dem Energiefilter ein zweites Ablenksystem und hinter dem Energiefilter ein drittes Ablenksystem vorgesehen sein. Jedes dieser drei Ablenksysteme kann dabei in bekannter Weise als Doppelablenksystem ausgebildet sein. Das erste und das zweite Ablenksystem sind dabei vorzugsweise derart erregt, daß ein parallel zur optischen Achse in das erste Ablenksystem eintretender Teilchenstrahl in der Maskenebene auf einen außerachsialen Bereich abgelenkt und hinter der Maskenebene wieder in Richtung auf die optische Achse zurückgelenkt wird. Durch das dritte Ablenksystem hinter dem Energiefilter erfolgt dann wieder eine außerachsiale Auslenkung. Mit der beschriebenen Kombination von Ablenksystemen können unterschiedliche Bereiche der in der Maskenebene anzuordnenden Maske auf unterschiedliche Bereiche auf dem in der Bildebene hinter dem Energiefilter aufzunehmenden Wafer abgebildet werden. Auf diese Weise können elektronenoptisch, d.h. ohne mechanische Bewegung der Maske und des Wafers relativ zueinander sukzessiv größere Maskenbereiche auf den Wafer abgebildet werden. Dabei ist es jedoch besonders vorteilhaft, wenn die teilchenoptische Ablenkung und die mechanische Bewegung des Maskenhalters in der Maskenebene und des Präparathalters in der Bildebene miteinander kombiniert werden, derart daß über eine geeignete Maschinensteuerung jeweils zwischen zwei mechanischen Bewegungen des Maskenhalters in der Maskenebene und des Präparathalters in der Bildebene jeweils zwei oder mehrere teilchenoptisch erzeugte Bildverschiebungen stattfinden.

Die in Verbindung mit der Erfindung zur Maskenabbildung eingesetzten Teilchen können Elektronen oder Ionen sein, wobei der Einsatz von Elektronen bevorzugt ist, da die für die Erfindung benötigten Komponenten grundsätzlich von Transmissionselektronenmikroskopen bekannt sind.

Nachfolgend werden Einzelheiten der Erfindung anhand der in den Figuren dargestellten Ausführungsbeispiele erläutert.

Dabei zeigen:
- Figur 1: eine vereinfachte Prinzipskizze einer erfindungsgemäßen teilchenoptischen Anordnung;

- Figur 2: eine perspektivische Darstellung eines Ausschnitts aus einer in Verbindung mit der Erfindung eingestzten Maske; und
- Figur 3: die Prinzipskizze eines Ausführungsbeispiels der Erfindung mit teilchenoptischer Bereichsauswahl in der Maskenebene.

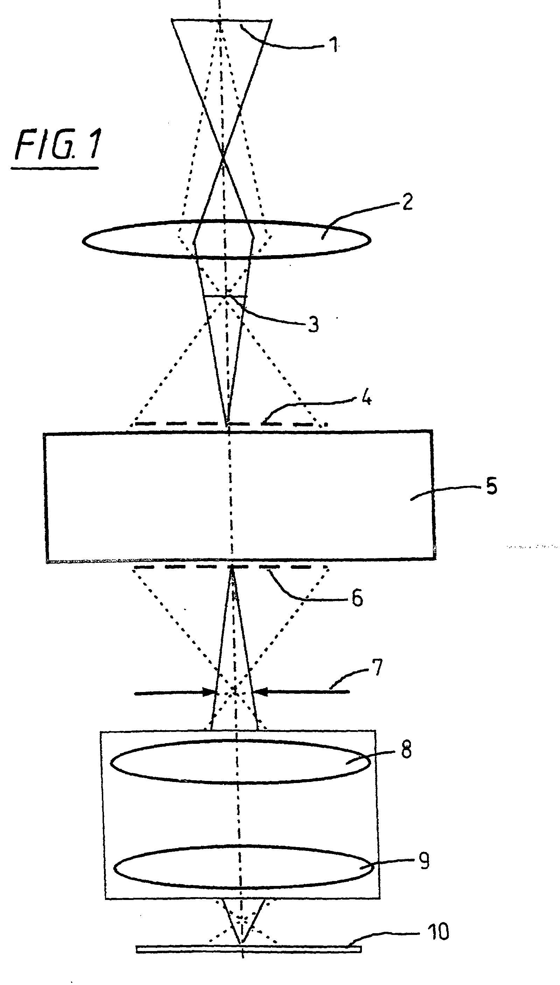

In der Figur 1 ist mit (1) der Crossover einer Teilchenquelle, beispielsweise einer Elektronenquelle, bezeichnet. Ein Kondensor (2) bildet diese Crossoverebene (1) reell in eine Crossoverebene (3) ab. Die Maskenebene (4) befindet sich - in Ausbreitungsrichtung der Teilchen gesehen - hinter der Crossoverebene (3), so daß eine in der Maskenebene (4) angeordnete Maske großflächig und gleichmäßig ausgeleuchtet wird.

Der Maskenebene (4) ist in Strahlrichtung ein Energiefilter (5) nachgeordnet. Dieses Energiefilter ist als sogenanntes abbildendes Energiefilter ausgebildet, das eine erste eingangsseitige Ebene, die Eingangsbildebene, achromatisch in eine erste ausgangsseitige Bildebene, die Ausgangsbildebene, und eine zweite eingangsseitige Ebene, die Eingangsbeugungsebene, dispersiv in eine zweite ausgangsseitige Ebene, die Selektionsebene oder dispersive Ebene abbildet. Derartige Energiefilter sind für Elektronen beispielsweise aus der US-A-4,740,704, US-A- 4,760,261 oder US-A- 5,449,914 bekannt. Auf deren detaillierten Aufbau braucht daher an dieser Stelle nicht näher eingegangen zu werden.

Bei der in Figur 1 dargestellten vereinfachten Anordnung fällt die Maskenebene (4) mit der Eingangsbildebene des Filters und die Crossoverebene (3) mit der Eingangsbeugungsebene des Energiefilters zusammen. Demzufolge bildet das Energiefilter (5) die Maskenebene (4) achromatisch in die Ausgangsbildebene (6) und die Crossoverebene (3) achromatisch in die Dispersionsebene (7) ab; der Abbildungsmaßstab sowohl für die Abbildung der Eingangsbildebene als auch für die Abbildung der Eingangsbeugungsebene sollte dabei 1:1 betragen, damit ein weitgehend symmetrischer Verlauf der Teilchenbahnen im Energiefilter gewährleistet ist, wodurch wiederum Abbildungsfehler im Filter vermieden werden. In der Dispersionsebene (7) ist eine Spaltblende angeordnet, durch die Teilchen, die einen vorbestimmten Energieverlust erfahren haben, selektiert werden. Der durch die Spaltblende (7) voreingestellte Energieverlust ist dabei auf den elementspezifischen Energieverlust der Mikrostruktur der in der Maskenebene (4) anzuordnenden Maske einstellbar.

In Ausbreitungsrichtung der Teilchen gesehen hinter der Spaltblende (7) folgt ein Projektionssystem (8, 9), durch das die Ausgangsbildebene (6) des Energiefilters (5) verkleinert in die Bildebene (10) abgebildet wird. Der Abbildungsmaßstab des Projektionssystems beträgt dabei etwa 0,25, so daß der vom Energiefilter (5) übertragene Bereich der Maskenebene (4) in der Bildebene (10) etwa auf ein Viertel verkleinert erscheint.

Bei dem vereinfachten, in der Figur 1 dargestellten Ausführungsbeispiel ist keine teilchenoptische Auswahl unterschiedlicher Bereiche in der Maskenebene (4) möglich. Um größere Maskenbereiche vollständig in die Bildebene (10) abzubilden, ist hier eine mechanische Relativbewegung sowohl der in der Maskenebene (4) anzuordnenden Maske als auch des in der Bildebene (10) anzuordnenden Wafers erforderlich. Für die entsprechende Bewegung der Maske und des Wafers können die bei elektronenoptischen Inspektionsgeräten eingesetzten Waferstages verwendet werden, die hier in der Figur 1 jedoch nicht dargestellt sind. Die Bewegungen der Waferstages in der Maskenebene (4) und in der Bildebene (10) sind dabei so miteinander zu koppeln, so daß das Verhältnis aus dem Bewegungshub der Maske und dem Bewegungshub des Wafers dem Abbildungsmaßstab zwischen der Maskenebene (4) und der Bildebene (10) entspricht.

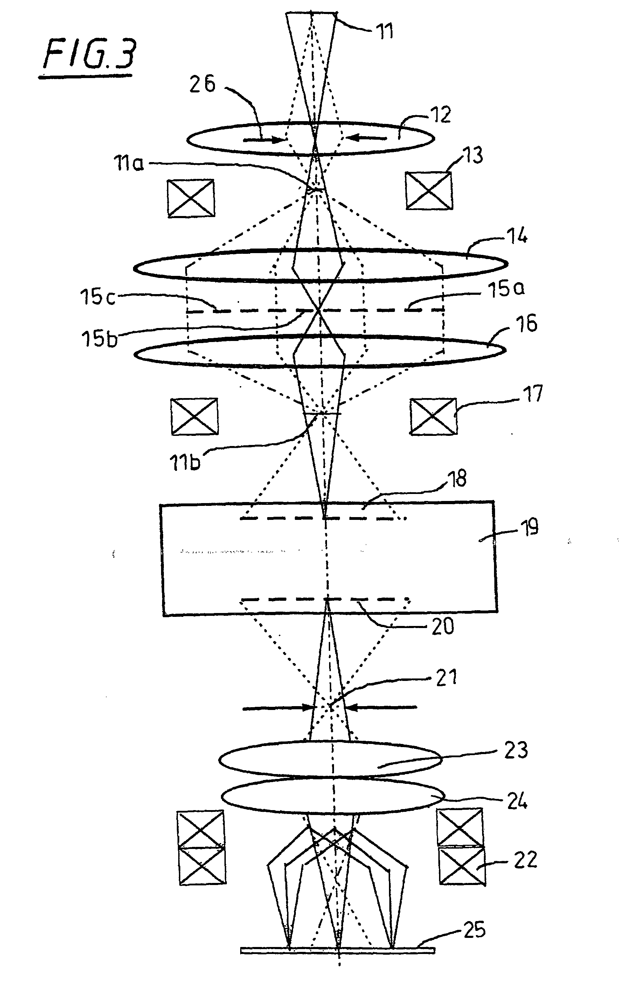

Beim Ausführungsbeispiel in Figur 3 ist die Teilchenquelle mit (11) bezeichnet. Auch hier erzeugt eine erste Kondensorlinse (12) ein reelles Bild (11a) der Quelle (11), einen sogenannten Crossover. In der Crossoverebene ist ein erstes Ablenksystem (13) angeordnet. Dem Ablenksystem (13) folgt eine zweite Kondensorlinse (14) nach, die den Crossover (11a) nach Unendlich abbildet. In Strahlrichtung hinter der zweiten Kondensorlinse (14) im parallelen Strahlengang befindet sich die Maskenebene (15). In der Maskenebene ist der für die Aufnahme der Maske vorgesehene Maskenhalter angeordnet.

Auch bei diesem Ausführungsbeispiel ist der Maskenhalter in zwei zueinander senkrechten Richtungen, die beide senkrecht zur optischen Achse des Abbildungssystems ausgerichtet sind, motorisch bewegbar, um dadurch unterschiedliche Bereiche der aufzunehmenden Maske in den teilchenoptischen Abbildungsstrahlengang zu bringen.

Der Maskenebene nach folgt eine dritte Kondensorlinse (16), durch die die Maskenebene (15) in die Eingangsbildebene (18) des Energiefilters (19) abgebildet wird. Die beiden Kondensorlinsen (14, 16) können dabei auch durch eine sogenannte Kondensor- Objektiv-Einfeldlinse realisiert sein.

Auch hier handelt es sich bei dem Energiefilter (19) um ein abbildendes Energiefilter, das die Eingangsbildebene (18) achromatisch in die Ausgangsbildebene (20) abbildet und gleichzeitig eine Eingangsbeugungsebene dispersiv in eine ausgangsseitige Selektionsebene (21) abbildet. In der Selektionsebene (21) ist wiederum eine Spaltblende vorgesehen, durch die ein vorgegebener Energieverlust einstellbar ist. Durch ein nachfolgendes Projektionssystem (23, 24) erfolgt wiederum eine verkleinerte Abbildung des in der Ausgangsbildebene (20) des Energiefilters (19) entstehenden Bildes der Maskenebene (15) in die Endbildebene (25).

Durch das erste Ablenksystem (13) in der Ebene des Crossovers (11a) vor der Maskenebene (15) kann je nach Erregung des Ablenksystems eine Ablenkung des Teilchenstrahls senkrecht zur optischen Achse erfolgen, so daß je nach Erregung des Ablenksystems (13) unterschiedliche laterale Bereiche (15a, 15b, 15c) in der Maskenebene (15) ausgeleuchtet werden. Der in der Maskenebene (15) telezentrisch außerachsial verlaufende Teilchenstrahl wird durch die dritte Kondensorlinse (16) wieder in Richtung optischer Achse zurückgelenkt. Durch ein zweites Ablenksystem (17), das in der hinteren Brennebene der dritten Kondensorlinse (16) angeordnet ist, erfolgt eine Rücklenkung bzw. Kippung des Teilchenstrahls, die gerade der durch das erste Ablenksystem (13) erzeugten Auslenkung so entgegen gerichtet ist, so daß hinter dem zweiten Ablenksystem (17) die weitere Ausbreitung des Teilchenstrahls unabhängig von der vom ersten Ablenksystem erzeugten Auslenkung ist. Demzufolge ist auch die Ausbreitung des Teilchenstrahls innerhalb des Energiefilters (19) unabhängig von der in der Maskenebene erzielten Strahlauslenkung. Ein drittes Ablenksystem (22), das eine Strahlablenkung um die optische Achse in der Selektionsebene (21) bewirkt, erzeugt wieder eine abschließende Strahlablenkung, die an die Strahlablenkung in der Maskenebene derart angekoppelt ist, daß neben einander liegende Bereiche in der Maskenebene sukzessiv auf neben einander liegende Bereiche in der Bildebene (25) abgebildet werden. Durch diese teilchenoptische Strahlauslenkung können insgesamt größere Feldbereiche in der Maskenebene (15) sukzessiv energiegefiltert in die Bildebene (25) abgebildet werden. Um jedoch noch größere Bildfelder aus der Maskenebene (15) in die Bildebene (25) zu übertragen, sollte auch bei diesem Ausführungsbeispiel der Präparathalter, der das zu strukturierende Präparat, in der Regel den Wafer, in der Bildebene (25) hält, als motorische Waferstage ausgebildet sein, so daß durch entsprechende miteinander gekoppelte Bewegung sowohl der in der Maskenebene (15) aufzunehmenden Maske als auch des in der Bildebene zu haltenden Wafers die gewünschten großen Bildfelder übertragen werden können. Dabei ist es allerdings sinnvoll, zwischen den mechanischen Bewegungen der Maske und des Wafers durch entsprechende Änderungen der Erregungen der Ablenksysteme (13, 17 und 22) durch teilchenoptische Strahlauslenkung jeweils zusammengesetzte größere Teilbildfelder zu erzeugen.

Auch beim Ausführungsbeispiel in der Figur 3 sind die einzelnen teilchenoptischen Komponenten vereinfacht dargestellt. So ist es bei den Ablenksystemen (13, 17, 22) nicht zwingend erforderlich, daß sie in den jeweils genannten Crossoverebenen angeordnet sind. Wichtig ist vielmehr, daß die Ablenksysteme zumindest virtuelle Strahlablenkungen um die Crossoverebenen erzeugen. Soweit die Crossoverebenen aus Platzgründen für ein einfaches Strahlablenksystem nicht zugänglich sind, können die Ablenksysteme in bekannter Weise, wie das Ablenksystem (22) hinter dem Projektionssystem (23, 24), auch als Doppelablenksysteme ausgebildet sein, die lediglich eine virtuelle Kippung in den genannten Crossoverebenen bewirken.

Soweit aufgrund der durch die Ablenksysteme erzeugten Ablenkungen die Kondensorlinsen und/oder die Projektivlinsen außeraxial von den Teilchen durchlaufen werden, kann eine Nachfokussierung der betreffenden Linsen sowie eine Änderung der in den Figuren nicht gezeigten Stigmatoren und Justier- und Korrekturelementen in Abhängigkeit von der durch die Ablenksysteme bewirkten Ablenkung erforderlich sein. Die für diese Nachfokussierung und/oder die Änderungen der Stigmatoren und Justier- und Korrekturelemente erforderlichen Strom- und Spannungsänderungen sind als Datentabelle in dem nicht dargestellten Steuerungsrechner abgespeichert, wobei den bewirkten Ablenkungen jeweils die zugehörigen Strom- bzw. Spannungsänderungen zugeordnet sind.

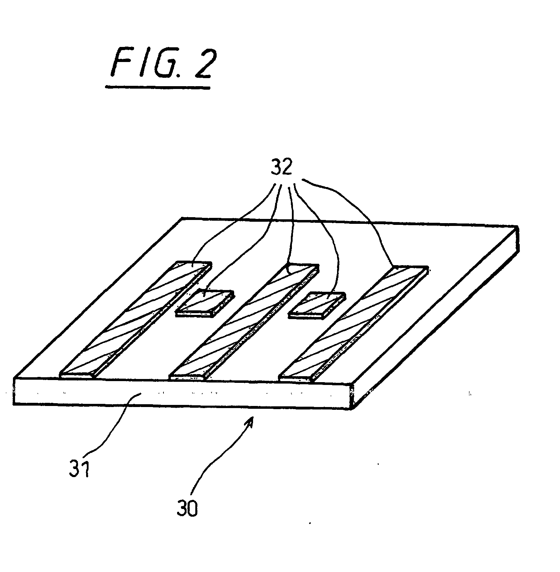

In der Figur 2 ist schematisch der Schnitt durch eine in Verbindung mit der erfindungsgemäßen Anordnung einsetzbaren Maske dargestellt. Die Maske (30) besteht aus einer dünnen Membran (31), beispielsweise aus Siliziumoxyd, auf die die gewünschten Mikrostrukturen (32) aufgebracht sind. Die Mikrostrukturen (32) weisen dabei ein anderes Material als die Membran (31) auf, so daß die mit den Mikrostrukturen (32) wechselwirkenden Teilchen einen anderen Energieverlust erfahren als diejenigen Teilchen, die außerhalb der Mikrostrukturen (32) die Maske (30) transmittiert haben.

Durch den erfindungsgemäßen Einsatz einer Energiefilterung bei der Abbildung der Maske ergeben sich gegenüber der bekannten Kontrasterzeugung durch Streuabsorption neben einem höheren Kontrast geringere Farbfehler. Denn da für die Abbildung der Maske in die Bildebene nur ein relativ enger energetischer Bereich der Teilchen ausgenutzt wird, haben die Farbfehler im Abbildungssystem einen geringeren Einfluß. Gleichzeitig wird auch die Energieverbreiterung durch die Wechselwirkung der Teilchen miteinander (Boerscheffekt) reduziert, da aufgrund der Energiefilterung die für die Abbildung nicht genutzten elastisch gestreuten Teilchen eliminiert sind.

## Patentansprüche

1. Teilchenoptische Anordnung mit einem zur Aufnahme einer Maske dienenden Maskenhalter in einer Maskenebene (4; 15) und einem dem Maskenhalter nachfolgenden abbildenden Energiefilter (5; 19), wobei die Maskenebene über das Energiefilter verkleinert in eine Bildebene (10; 25) abgebildet ist.

2. Teilchenoptische Anordnung nach Anspruch 1, wobei das abbildende Energiefilter (5; 19) eine erste eingangsseitige Ebene (4; 18) achromatisch in eine erste ausgangsseitige Ebene (6; 20) und eine zweite eingangsseitige Ebene (3; 17) dispersiv in eine zweite ausgangsseitige Ebene (7; 21) abbildet und wobei die Maskenebene in der ersten eingangsseitigen Ebene (4; 18) angeordnet oder in diese abgebildet ist.

3. Teilchenoptische Anordnung nach Anspruch 1 oder 2, wobei dem Energiefilter ein verkleinerndes Abbildungssystem (8, 9; 23, 24) nachgeordnet ist.

4. Teilchenoptisches Abbildungssystem nach einem der Ansprüche 1-3, wobei in der Bildebene (10; 25) ein Präparathalter angeordnet ist, der in zwei zueinander senkrechten Richtungen motorisch bewegbar ist.

5. Teilchenoptische Anordnung nach Anspruch 4, wobei der Maskenhalter in der Maskenebene (4; 15) in zwei zueinander senkrechten Richtungen motorisch bewegbar ist und die Bewegung des Maskenhalters und die Bewegung des Präparathalters miteinander gekoppelt sind.

6. Teilchenoptisches Abbildungssystem nach einem der Ansprüche 1-5, wobei zwischen der Teilchenquelle (11) und der Maskenebene (4; 15) ein Kondensorsystem (2; 12, 14) vorgesehen ist.

7. Teilchenoptisches Abbildungssystem nach einem der Ansprüche 1-6, wobei zwischen der Teilchenquelle (11) und der Maskenebene (15) ein erstes Ablenksystem (13), zwischen der Maskenebene und dem Energiefilter (19) ein zweites Ablenksystem (17) und dem Energiefilter nachgeschaltet ein drittes Ablenksystem (22) vorgesehen ist.

8. Teilchenoptisches Abbildungssystem nach Anspruch 7, wobei das erste und zweite Ablenksystem (13, 17) derart erregt sind, daß ein parallel zur optischen Achse verlaufender Teilchenstrahl in der Maskenebene (15) einen außerachsialen Bereich (15a, 15c) durchläuft, hinter der Maskenebene (15) wieder in Richtung auf die optische Achse zurückgelenkt und hinter dem Energiefilter durch das dritte Ablenksystem (22) wieder auf einen außerachsialen Bereich in der Bildebene (25) abgelenkt wird.

9. Teilchenoptisches Abbildungssystem nach Anspruch 8, wobei bei einer Änderung der durch die Ablenksysteme (13, 17, 20) bewirkten Ablänkung eine Änderung der Erregung der Kondensorlinsen (14, 16) und/oder weiterer Elemente wie Stigmatoren und Justier- und Korrekturelemente erfolgt.

10. Teilchenoptisches Abbildungssystem nach einem der Ansprüche 1-9, wobei die Maskenebene (15) sich in einem kollimierten Strahlengang befindet.

11. Verfahren zur teilchenoptischen Erzeugung von Mikrostrukturen, wobei eine Maske (30) mit inelastisch streuenden Mikrostrukturen (32) eingesetzt und über ein Energiefilter (5; 19) verkleinert auf einen Wafer abgebildet wird und wobei mit dem Energiefilter (5; 19) Teilchen mit einem voreingestellten Energieverlust selektiert werden.

12. Verfahren nach Anspruch 11, wobei die Maske aus einer dünnen Trägerfolie (31) mit inelastisch streuenden Mikrostrukturen (32) besteht.

13. Verfahren nach Anspruch 11 oder 12, wobei die Trägerfolie (31) aus einem elastisch streuenden Material besteht.

## Claims

1. Particle-optical arrangement having a mask holder used for holding a mask in a mask plane (4; 15) and an imaging energy filter (5; 19) downstream of the mask holder, wherein the mask plane is imaged at a reduced scale into an image plane (10; 25) by means of the energy filter.

2. Particle-optical arrangement according to Claim 1, wherein the imaging energy filter (5; 19) images a first input-side plane (4; 18) achromatically into a first output-side plane (6; 20) and a second input-side plane (3; 17) dispersively into a second output-side plane (7; 21), and wherein the mask plane is arranged in or imaged into the first input-side plane (4; 18).

3. Particle-optical arrangement according to Claim 1 or 2, wherein a reduction imaging system (8, 9; 23, 24) is arranged upstream of the energy filter.

4. Particle-optical imaging system according to one of Claims 1 - 3, wherein a preparation holder, which can be moved by motors in two mutually perpendicular directions, is arranged in the image plane (10; 25).

5. Particle-optical arrangement according to Claim 4, wherein the mask holder can be moved by motors in two mutually perpendicular directions in the mask plane (4; 15) and the movement of the mask holder and the movement of the preparation holder are coupled together.

6. Particle-optical imaging system according to one of Claims 1 - 5, wherein a condensor system (2; 12, 14) is provided between the particle source (11) and the mask plane (4; 15).

7. Particle-optical imaging system according to one of Claims 1 - 6, wherein a first steering system (13) is provided between the particle source (11) and the mask plane (15), a second steering system (17) is provided between the mask plane and the energy filter (19) and a third steering system (22) is provided downstream of the energy filter.

8. Particle-optical imaging system according to Claim 7, wherein the first and second steering systems (13, 17) are actuated so that a particle beam travelling parallel to the optical axis passes through an off-axial region (15a, 15c) in the mask plane (15), is steered back into the direction of the optical axis behind the mask plane (15) and is again steered onto an off-axial region in the image plane (25) behind the energy filter by the third steering system (22).

9. Particle-optical imaging system according to Claim 8, wherein the actuation of the condenser lenses (14, 16) and/or other elements, such as stigmators and alignment or correction elements, is changed in the event of a change in the steering caused by the steering systems (13, 17, 20).

10. Particle-optical imaging system according to one of Claims 1 - 9, wherein the mask plane (15) lies in a collimated beam path.

11. Method for generating microstructures by particle optics, wherein a mask (30) having inelastically scattering microstructures (32) is used and is imaged at a reduced scale onto a wafer by means of an energy filter (5; 19), and wherein particles having a predefined energy loss are selected by using the energy filter (5; 19).

12. Method according to Claim 11, wherein the mask consists of a thin support sheet (31) having inelastically scattering microstructures (32).

13. Method according to Claim 11 or 12, wherein the support sheet (31) consists of an elastically scattering material.

## Revendications

1. Appareil d'optique par particules qui présente un porte-masque qui sert à reprendre un masque dans un plan de masque (4; 15) et à la suite de celui-ci un filtre d'énergie (5; 19) qui forme l'image, l'image du plan de masque étant formée par le filtre d'énergie à une taille plus petite dans un plan d'image (10; 25).

2. Appareil d'optique par particules selon la revendication 1, dans lequel le filtre d'énergie (5; 19) qui forme l'image forme achromatiquement celle d'un premier plan (4; 18) situé du côté de l'entrée dans un premier plan (6; 20) situé du côté de la sortie et dispersivement celle d'un deuxième plan (3; 17) situé du côté de l'entrée dans un deuxième plan (7; 21) situé du côté de la sortie, le plan du masque étant situé dans le premier plan (4; 18) situé du côté de l'entrée ou sont image étant formée dans ce plan.

3. Appareil d'optique par particules selon les revendications 1 ou 2, dans lequel un système (8, 9; 23, 24) de formation d'images de plus petite taille est raccordé en aval du filtre d'énergie.

4. Appareil d'optique par particules selon l'une des revendications 1 à 3, dans lequel un support de préparation qui peut être déplacé par moteur dans deux directions perpendiculaires est placé dans le plan d'image (10; 25).

5. Appareil d'optique par particules selon la revendication 4, dans lequel le porte-masque disposé dans le plan de masque (4; 15) peut être déplacé par moteur dans deux directions perpendiculaires, le déplacement du porte-masque et le déplacement du support de préparation étant couplés mutuellement.

6. Système optique d'imagerie par particules selon l'une des revendications 1 à 5, dans lequel un système de condenseur (2; 12, 14) est prévu entre la source (11) de particules et le plan de masque (4; 15).

7. Système optique d'imagerie par particules selon l'une des revendications 1 à 6, dans lequel un premier système de déviation (13) est prévu entre la source (11) de particules et le plan de masque (15), un deuxième système de déviation (17) est prévu entre le plan de masque et le filtre d'énergie (19) et un troisième système de déviation (22) est raccordé en aval du filtre d'énergie.

8. Système optique d'imagerie par particules selon la revendication 7, dans lequel le premier et le deuxième système de déviation (13, 17) sont excités de telle sorte qu'un faisceau de particules qui s'étend parallèlement à l'axe optique traverse une partie (15a, 15c) non axiale du plan de masque (15), est ramené en direction de l'axe optique en aval du plan de masque (15) et est de nouveau dévié sur une partie non axiale du plan d'image (25) par le troisième système de déviation (22) en aval du filtre d'énergie.

9. Système optique d'imagerie par particules selon la revendication 8, dans lequel une modification de l'excitation des lentilles de condenseur (14, 16) et/ou d'autres éléments tels que des stigmateurs et des éléments d'ajustement et de correction accompagne la modification de la déviation effectuée par les systèmes de déviation (13, 17, 20).

10. Système optique d'imagerie par particules selon l'une des revendications 1 à 9, dans lequel le plan de masque (15) est situé dans un parcours de faisceau collimaté.

11. Procédé de création optique de microstructures par particules, qui utilise un masque (30) qui présente des microstructures (32) de dispersion inélastique dont la taille est diminuée par un filtre d'énergie (5; 19) et dont l'image est formé sur une galette, les particules étant sélectionnées par le filtre d'énergie (5; 19) avec une perte d'énergie préréglée.

12. Procédé selon la revendication 11, dans lequel le masque est constitué d'une mince feuille de support (31) qui présente des microstructures (32) de dispersion inélastique.

13. Procédé selon les revendications 11 ou 12, dans lequel la feuille de support (31) est constituée d'un matériau de dispersion élastique.
